# FASCICULE DE BREVET EUROPEEN

(11) **EP 0 821 410 B1**
(45) Date de publication et mention de la délivrance du brevet: **06.05.2004**
(21) Numéro de dépôt: 97410079.4
(22) Date de dépôt: 24.07.1997
(51) Int. Cl.: H01L 27/06, H01L 29/74

(54) **Composant monolithique semiconducteur associant un composant haute tension et des composants logiques**
Monolithische Halbleiteranordnung zur Verbindung eines Hochspannungsbauteil und logischer Bauteile
Semiconducting monolithic device associating a high-voltage device and logic devices

(30) Priorité: 26.07.1996 FR 9609682
(43) Date de publication de la demande: 28.01.1998
(73) Titulaire: STMicroelectronics S.A., 92120 Montrouge (FR)
(72) Inventeur: Pezzani, Robert, 37210 Vouvray (FR); Bernier, Eric, 37390 Mettray (FR)
(74) Mandataire: de Beaumont, Michel

(56) Documents cités:
- FR-A- 2 081 946
- PATENT ABSTRACTS OF JAPAN vol. 005, no. 027 (E-046), 18 février 1981 & JP 55 154764 A (MITSUBISHI ELECTRIC CORP), 2 décembre 1980,
- PATENT ABSTRACTS OF JAPAN vol. 014, no. 190 (E-0918), 18 avril 1990 & JP 02 039470 A (MATSUSHITA ELECTRON CORP), 8 février 1990,

## Description

La présente invention concerne la réalisation sous forme monolithique d'au moins un composant haute tension et de circuits logiques.

Les composants haute tension, tels que des thyristors, susceptibles de bloquer des tensions supérieures à 600 V, sont généralement réalisés dans des tranches semiconductrices, l'une des couches constitutives du composant correspondant sensiblement à l'épaisseur de la tranche. On s'intéressera plus particulièrement ici aux technologies dans lesquelles la face arrière du composant est uniformément revêtue d'une métallisation en contact direct avec le semiconducteur.

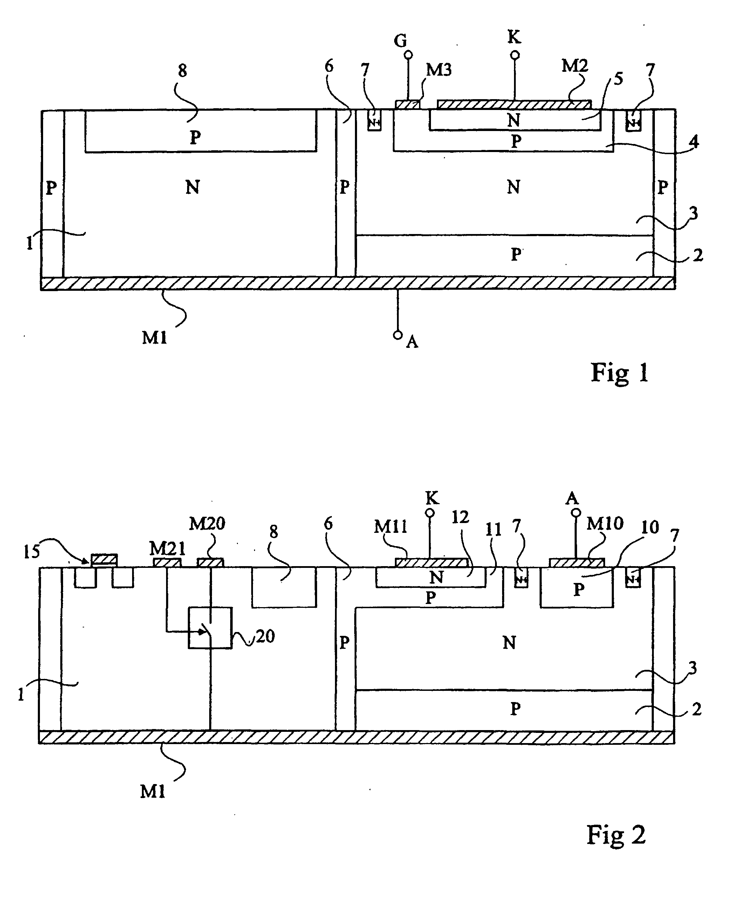

La figure 1 illustre un exemple de réalisation classique d'une structure monolithique associant un composant haute tension et des circuits logiques.

Cette structure est réalisée dans une tranche semiconductrice 1, par exemple de type N. Dans la partie droite, 3, de la tranche est représenté un thyristor vertical. Du côté de la face arrière du substrat 1 est formée une région 2 de type P et du côté de la face avant un caisson 4 de type P dans lequel est formée une région 5 de type N. Une métallisation d'anode M1 est solidaire de la face arrière. Une métallisation de cathode M2 recouvre la région 5. Une métallisation M3 recouvre une portion de la région 4 de type P et constitue la gâchette de cathode G du thyristor. Ce thyristor vertical est isolé du reste de la structure monolithique par un mur 6 de type P, généralement formé au début du processus de fabrication par des diffusions profondes s'étendant à partir des faces supérieure et inférieure de la tranche. On a désigné par la référence 7 des régions de type N⁺ servant, de façon classique, d'arrêt de canal. Du côté gauche du substrat, isolé du thyristor par le mur 6, peuvent être formés divers composants logiques dans un caisson 8 de type P. Toutefois, comme la face arrière du substrat 1 de type N est revêtue de la métallisation M1, elle est susceptible de se trouver au potentiel le plus élevé appliqué à cette métallisation, par exemple un potentiel de l'ordre du millier du volt. Ceci impose de très nombreuses contraintes d'isolement sur les composants formés dans le caisson 8 et rend très difficile de former des composants directement dans la face supérieure du substrat 1.

Dans l'art antérieur, diverses solutions ont été recherchées pour améliorer cette situation et notamment pour polariser de façon satisfaisante le caisson 8 pour que celui-ci reste convenablement isolé de la haute tension.

Une solution de l'art antérieur pour résoudre ce problème d'isolement de la partie logique, consiste à revêtir le fond de la tranche en regard de la partie logique d'une couche isolante sur laquelle est ensuite déposée la métallisation M1. Cette technique donne d'excellents résultats mais peut être complexe à mettre en oeuvre et être incompatible avec certaines filières technologiques.

Le document JP-A-55154764 décrit un composant monolithique dans une tranche semiconductrice selon le préambule de la revendication 1.

Un objet de la présente invention est de prévoir une structure monolithique incorporant un composant haute tension et des circuits logiques et réduisant les contraintes d'isolement imposées au circuit logique.

Un autre objet de la présente invention est de prévoir une telle structure monolithique dans laquelle le circuit logique comporte un composant vertical dont la borne de face arrière correspond à la borne de commande d'un composant haute tension intégré.

Un autre objet de la présente invention est de prévoir une telle structure monolithique simplement fabriquable en utilisant des techniques courantes.

Pour atteindre ces objets, la présente invention prévoit un composant monolithique selon les revendications.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente une structure monolithique incorporant un composant haute tension et des circuits logiques selon l'art antérieur ;
la figure 2 représente, partiellement sous forme de blocs, une structure monolithique incorporant un composant haute tension et des circuits logiques selon la présente invention ;
la figure 3 représente un exemple d'application de la présente invention ;
la figure 4 représente un circuit dont une partie est mise en oeuvre par le composant de la figure 3 ; et
les figures 5 et 6 représentent partiellement sous forme de blocs, des variantes de structures monolithiques incorporant un composant haute tension et des circuits logiques selon la présente invention.

Selon la présente invention, il est prévu d'utiliser un composant haute tension de type latéral. Alors, la face arrière de la structure se trouve à un potentiel bas correspondant sensiblement au potentiel de l'électrode de commande de ce composant et les contraintes d'isolement des circuits logiques disparaissent. Cette approche surmonte un préjugé selon lequel, quand on veut obtenir un composant haute tension, il faut utiliser une structure verticale. En fait, les inventeurs ont noté qu' il faut seulement prévoir dans la structure du composant au moins une couche épaisse susceptible de tenir une haute tension, c'est-à-dire une couche occupant sensiblement l'épaisseur d'une tranche semiconductrice. Un composant latéral formé sur un substrat massif satisfait à cette exigence.

En outre, la présente invention prévoit de disposer un composant vertical dans la partie logique de la structure, ce composant vertical constituant un interrupteur dont une borne est reliée à la borne de commande du composant haute tension.

La figure 2 illustre, partiellement sous forme de blocs, un mode de réalisation de la présente invention dans lequel le composant haute tension est un thyristor.

La partie droite de la figure 2 représente un thyristor latéral, séparé par un mur d'isolement 6 de type P de composants logiques formés dans la partie gauche de la figure. Le thyristor latéral est formé dans un caisson 3 du substrat 1 délimité par le mur d'isolement 6 et une couche 2 de face arrière de type P. Une première région 10 de type P constituant l'anode du thyristor. Une deuxième région 11 de type P constitue sa région de gâchette de cathode et contient une région 12 de type N formant sa cathode. Une métallisation M10 est formée sur la région 10 et correspond à l'anode du thyristor latéral. Une métallisation M11 est en contact avec la région 12 et constitue la cathode du thyristor latéral. La région de gâchette de cathode 11 est en contact avec le mur d'isolement 6 ou lui est connectée par une métallisation (non représenté). On notera que la métallisation de face arrière M1 est reliée électriquement à cette région de gâchette par l'intermédiaire du mur d'isolement 6 et peut constituer une connexion de gâchette.

La couche de face arrière 2 de type P a non seulement une fonction d'isolement mais aussi une fonction d'augmentation du gain du thyristor latéral.

La région de gâchette du thyristor est à un potentiel voisin de celui de sa cathode. La cathode étant généralement reliée à la masse, la métallisation M1 est à un potentiel compris entre 0 et une dizaine de volts, c'est-à-dire une valeur bien inférieure à la tension maximale d'anode (de l'ordre du millier de volts).

En conséquence, on peut former sans précaution particulière des composants logiques dans la partie gauche de la structure, séparée du composant haute tension par le mur d'isolement 6. Ces composants logiques peuvent ou bien être formés dans un caisson 8 de type P ou bien, comme le transistor MOS 15, directement dans la face supérieure du substrat 1. De nombreux composants logiques, de types bipolaires ou MOS pourraient être utilisés.

En outre, la présente invention prévoit de disposer dans la partie logique un composant vertical constituant un interrupteur 20 dont une borne correspond à la métallisation de face arrière M1 et dont une autre borne est reliée, éventuellement par l'intermédiaire d'autres composants, à une métallisation M20 et dont une borne de commande est reliée, éventuellement avec interposition d'autres composants, à une métallisation M21.

Cette structure est particulièrement attrayante car, dans une structure monolithique incorporant un composant haute tension et un circuit logique, le circuit logique comporte toujours une connexion avec la borne de commande du composant haute tension. Ici, cette connexion est réalisée en réduisant au maximum la surface du circuit logique et le nombre de métallisations formées sur la face supérieure puisqu'elle est assurée directement dans l'épaisseur de la tranche.

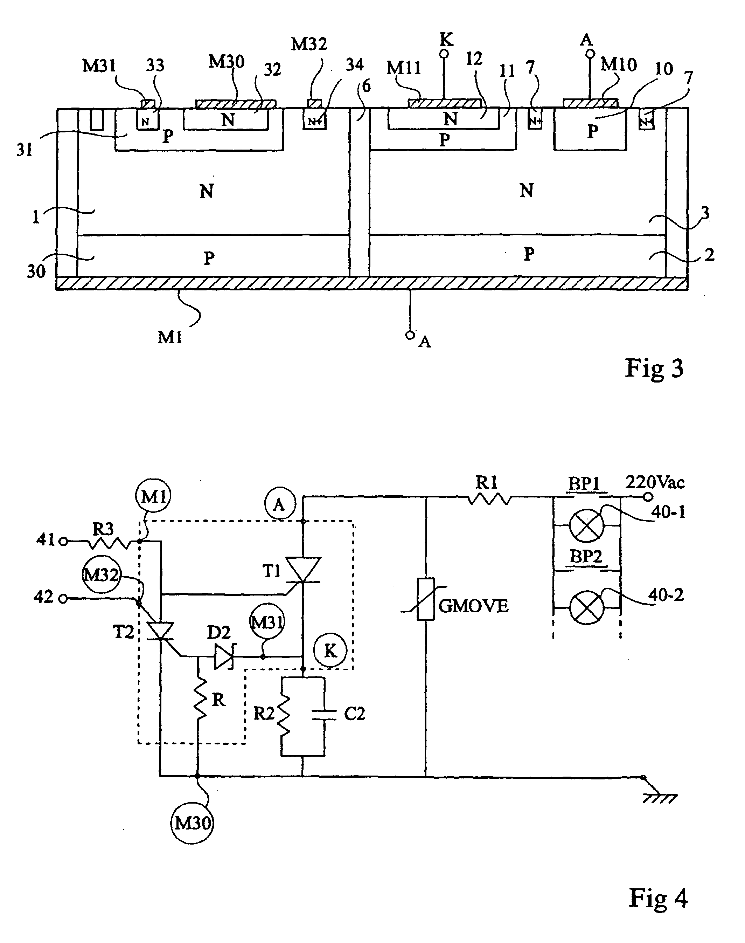

Un exemple particulier d'application de la présente invention est illustré en figure 3. Le composant haute tension est identique à celui illustré en figure 2. Du côté de la partie logique, est réalisée, sur la face arrière de la structure, une couche 30 de type P, identique à la région 2 et qui de façon commode sera formée lors d'une même étape de fabrication, c'est-à-dire que l'on pourra faire une diffusion sans masquage de la face arrière du composant, ce qui simplifie sa fabrication. Dans la face supérieure du substrat, on trouve un caisson 31 de type P dans lequel sont formées une région principale 32 et une région auxiliaire 33 de type N. Une région 34 de type N fortement dopée est formée directement dans la surface supérieure du substrat, en dehors du caisson 31. La région 32 et une région adjacente du caisson 31 sont revêtues d'une métallisation M30. La région 33 est revêtue d'une métallisation M31. La région 34 est revêtue d'une métallisation M32.

Le circuit logique formé dans la partie gauche de la figure correspond à la partie encadrée d'un pointillé du circuit de la figure 4. Seule cette partie sera considérée ici, le reste du circuit sera décrit par la suite.

L'ensemble des couches 30-1-31-32 forme un thyristor vertical T2 dont l'anode correspond à la métallisation M1 et la cathode à la métallisation M30. La métallisation M1 correspond à une borne extérieure et à une liaison entre l'anode du thyristor T2 et la gâchette de cathode du thyristor haute tension T1 formé dans la partie droite du composant. Ce thyristor T1 est susceptible de supporter la tension du secteur. La métallisation M32 correspond à la gâchette d'anode du thyristor T2. La métallisation M30 correspond à la cathode 32 du thyristor T2 et à une borne d'une résistance R dont l'autre borne est reliée à la gâchette de cathode de ce thyristor. La métallisation M31 correspond à la cathode d'une diode Zener D2 dont l'anode est reliée à la gâchette du thyristor T2. Cette métallisation M31 est reliée à la métallisation de cathode K ou commune avec celle-ci.

Ainsi, on a formé un élément principal d'un système de commande de batterie de tubes néon à bouton poussoir tel que représenté en figure 4.

Le circuit de la figure 4 est un circuit de type microdisjoncteur à thyristor associé à des tubes fluorescents, couramment appelés tubes néon 40-1, 40-2 etc, disposés en parallèle et associés à des boutons poussoirs de mise en court-circuit BP1, BP2 etc. Une borne de ces tubes néon est connectée au secteur (220 V_{ac}) et leur autre borne est reliée à la deuxième borne du secteur, couramment la masse, par l'intermédiaire d'une résistance R1, du thyristor principal T1, et du montage en parallèle d'une résistance R2 et d'un condensateur C2. Un composant de protection (GMOVE) est disposé entre l'anode du thyristor T1 et la masse. Les autres composants de ce circuit ont déjà été décrits en relation avec la figure 3.

A l'état normal, la tension sur une borne 41, reliée par l'intermédiaire d'une résistance R3 à la gâchette du thyristor T1 et à l'anode du thyristor T2 est à un potentiel positif, par exemple 5 V. Ainsi, le thyristor T1 est passant et les tubes néon sont allumés.

Quand un bouton poussoir est pressé, un ou plusieurs des tubes néon sont court-circuités et le courant augmente dans le thyristor T1. Il en résulte une augmentation de la tension sur le condensateur C2. Quand cette tension atteint la valeur d'avalanche de la diode zener 2, le thyristor T2 est mis en conduction et la gâchette du thyristor T1 se trouve à un potentiel plus négatif que sa cathode. Cette différence est suffisante pour désamorcer le thyristor T1 qui se bloque. Ainsi, le courant dans les tubes néon est interrompu. Cet état demeure tant que le potentiel sur la borne 41 est à 5 V.

Pour réamorcer le système, il convient de ramener la tension (RESET) sur la borne 41 à 0 volt, ce qui désamorce le thyristor T2, puis à nouveau à 5 V, ce qui réamorce le thyristor T1. De préférence, le circuit comprend en outre une borne 42 (correspondant à la métallisation M32), c'est-à-dire à la gâchette d'anode du thyristor T2. La tension sur cette borne constitue une indication de l'état conducteur ou non du thyristor T2. Une tension de l'ordre de 5 V indique que le thyristor T2 est bloqué, une tension de l'ordre de 0 V indique que le thyristor T2 est passant. Ceci traduit l'état de conduction ou non dans les tubes néon.

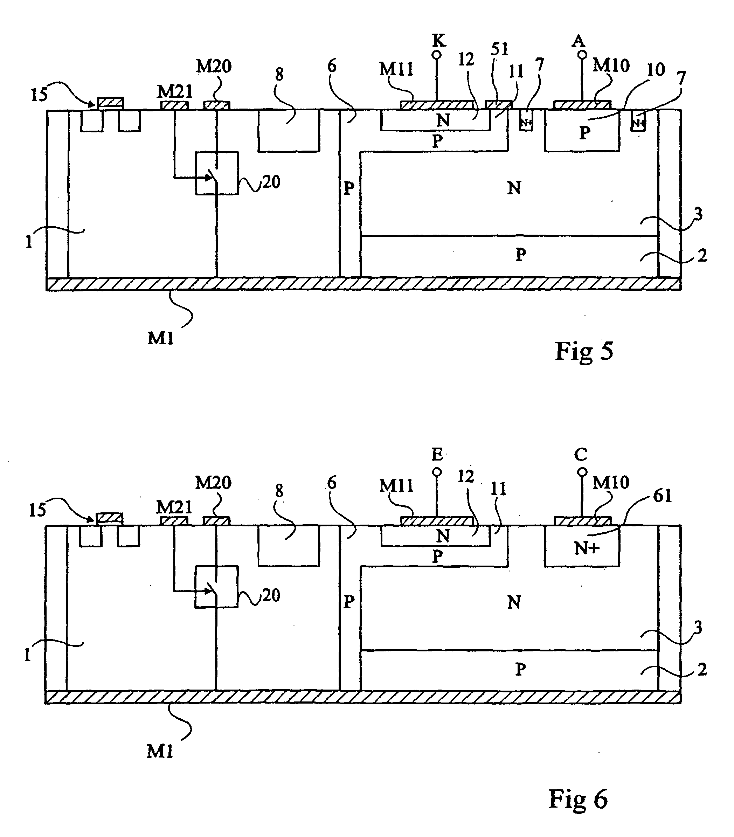

Les figures 5 et 6 représentent des variantes de la présente invention et constituent deux exemples de structure selon la présente invention qui se différencient par la nature du composant latéral de puissance. Ces figures 5 et 6 reprennent sensiblement le dessin de la figure 2 et de mêmes éléments y sont désignés par de mêmes références.

En figure 5, le thyristor de puissance est modifié et il y est ajouté une grille isolée 51. La grille 51 est disposée au-dessus d'une portion de la région de gâchette de cathode 11 du thyristor qui sépare la région de cathode 12 du substrat 1. On obtient ainsi un thyristor qui peut être commandé à la fermeture par une action sur la grille et commandé à l'ouverture par une action sur la gâchette, correspondant à la métallisation de face arrière.

Dans le cas de la figure 6, le thyristor est remplacé par un transistor NPN latéral, c'est-à-dire que la région 10 de type P est remplacée par une région 61 de type N⁺. Alors, la métallisation M10 correspond à une borne de collecteur C et la métallisation M11 à une borne d'émetteur E. La métallisation de face arrière M1 correspond alors à une borne de base.

## Revendications

1. Composant monolithique formé dans une tranche semiconductrice (1) faiblement dopée d'un premier type de conductivité, comprenant au moins deux parties séparées par un mur d'isolement (6) d'un deuxième type de conductivité opposé au premier type de conductivité, une première partie contenant au moins un commutateur commandé haute tension dont une couche correspond sensiblement à l'épaisseur de la tranche, et une deuxième partie contenant des éléments de circuit logique, la face arrière étant uniformément revêtue d'une métallisation (M1) en contact avec des zones semiconductrices de la tranche, la partie logique comprenant au moins un interrupteur vertical (20) dont une borne principale correspond à la métallisation de face arrière, le commutateur commandé haute tension étant réalisé sous forme latérale,
**caractérisé en ce que** le mur d'isolement est en contact électrique direct avec une région de commande du commutateur commandé, ladite région de commande étant du même type de conductivité que le mur d'isolement, et ledit mur d'isolement traverse entièrement la tranche semiconductrice de la face supérieure à la face inférieure de la tranche.

2. Composant monolithique selon la revendication 1, **caractérisé en ce que** la face arrière de la tranche comporte une couche (2) du type de conductivité opposé à celui de la tranche.

3. Composant monolithique selon la revendication 1, **caractérisé en ce que** la tranche (1) est de type N, le mur d'isolement (6) est de type P, et le commutateur commandé haute tension est un thyristor latéral dont la région de gâchette de cathode (11) est reliée directement au mur d'isolement.

4. Composant monolithique selon la revendication 1, **caractérisé en ce que** ledit interrupteur vertical de la partie logique est un thyristor.

5. Composant monolithique selon la revendication 1, **caractérisé en ce que** le commutateur commandé haute tension est un transistor latéral dont la région de base est reliée directement au mur d'isolement.

6. Composant monolithique selon la revendication 1, **caractérisé en ce que** le commutateur commandé haute tension est un thyristor latéral à fermeture par une grille isolée et à ouverture par la gâchette dont la région de gâchette de cathode (11) est reliée directement au mur d'isolement.

## Claims

1. A monolithic component formed in a lightly-doped semiconductor wafer (1) of a first type of conductivity, including at least two portions separated by an insulating wall (6) of a second type of conductivity opposed to the first conductivity type, a first portion including at least one high voltage controlled switch, a layer of which substantially corresponds to a thickness of the wafer, and a second portion including logic circuit components, a lower surface of the wafer being uniformly coated with a metallization (M1) in contact with semiconductor areas of the wafer, the logic portion includes at least one vertical switch (20) having a main terminal which corresponds to the lower surface metallization, the high voltage controlled switch being implemented laterally,
**characterized in that** the insulating wall is in direct electrical contact with a control region of the controlled switch said control region having the same conductivity type as the insulating wall, and the insulating wall full crossing the semiconductor wafer from the upper surface to the lower surface of the wafer.

2. A monolithic component according to claim 1, wherein the lower surface of the wafer includes a layer (2) having an opposite type of conductivity to that of the wafer.

3. A monolithic component according to claim 1, wherein the wafer (1) is of type N, the insulating wall (6) is of type P, and the high voltage controlled switch is a lateral thyristor having a cathode gate region that is directly connected to the insulating wall.

4. A monolithic component according to claim 1, wherein the vertical switch of the logic portion is a thyristor.

5. A monolithic component according to claim 1, wherein the high voltage controlled switch is a lateral transistor having a base region that is directly connected to the insulating wall.

6. A monolithic component according to claim 1, wherein the high voltage controlled switch is a lateral insulated gate turn-on and gate turn-off thyristor, having a cathode gate region (11) that is directly connected to the insulating wall.

## Patentansprüche

1. Monolithische Komponente, die in einer mit einem ersten Leitungstyp schwach dotierten Halbleiterscheibe (1) gebildet ist, mit mindestens zwei durch einen Isolationswall (6) eines zweiten und dem ersten Leitungstyp entgegengesetzten Leitungstyp getrennten Bereichen, wobei ein erster Bereich zumindest einen durch eine Hochspannung gesteuerten Schalter, dessen Schicht der Dicke der Scheibe entspricht, und ein zweiter Bereich Elemente eines logischen Schaltkreises enthält, wobei die Rückseite gleichmäßig mit einer in Kontakt mit Halbleiterzonen der Scheibe stehenden Metallisierung (M1) bedeckt ist, wobei der Logikbereich zumindest einen vertikalen Unterbrecher (20) aufweist, dessen einer Hauptanschluss der Metallisierung der Rückseite entspricht, und wobei der durch eine Hochspannung gesteuerte Schalter in lateraler Form realisiert ist,
**dadurch gekennzeichnet, dass** der Isolationswall in direktem elektrischen Kontakt mit einer Steuerregion des gesteuerten Schalters ist, wobei diese Steuerregion von gleichem Leitungstyp wie der Isolationswall ist, und dass der Isolationswall vollständig die Halbleiterscheibe von der Oberseite bis zur Unterseite der Scheibe durchquert.

2. Monolithische Komponente nach Anspruch 1, **dadurch gekennzeichnet, dass** die Rückseite der Scheibe eine Schicht (2) mit einem Leitungstyp entgegengesetzt demjenigen der Scheibe aufweist.

3. Monolithische Komponente nach Anspruch 1, wobei die Scheibe vom N-Typ der Isolationswall vom P-Typ und dass der mit Hochspannung gesteuerte Schalter ein lateraler Thyristor ist, dessen Gate-Region der Kathode direkt mit dem Isolationswall verbunden ist.

4. Monolithische Komponente nach Anspruch 1, **dadurch gekennzeichnet, dass** der vertikale Unterbrecher des Logikbereiches ein Thyristor ist.

5. Monolithische Komponente nach Anspruch 1, **dadurch gekennzeichnet, dass** der mit Hochspannung gesteuerte Schalter ein lateraler Transistor ist, dessen Basisregion direkt mit dem Isolationswall verbunden ist.

6. Monolithische Komponente nach Anspruch 1, **dadurch gekennzeichnet, dass** der mit Hochspannung gesteuerte Schalter ein lateraler Thyristor ist, der durch ein isoliertes Gitter geschlossen und durch das Gate geöffnet werden kann, dessen Gate-Region der Kathode (11) direkt mit dem Isolationswall verbunden ist.
